# EUROPEAN PATENT APPLICATION

(11) **EP 2 164 118 A1**
(43) Date of publication of application: **17.03.2010**
(21) Application number: 09169929.8
(22) Date of filing: 10.09.2009
(51) Int. Cl.: H01L 41/08, H01L 41/04, G02B 26/08

(54) **Actuator using piezoelectric element and method of driving the same**

(30) Priority: 10.09.2008 KR 20080089328
(71) Applicant: Samsung Electronics Co., Ltd., Suwon-si, Gyeonggi-do 442-742 (KR)
(72) Inventor: Cheong, Young-Min, Seoul (KR); Lee, Kyoung-woo, Gyeonggi-do (KR); Kwon, Jae-hwan, Seoul (KR); So, Hyoung-jong, Gyeonggi-do (KR); Kim, Hong-hee, Gyeonggi-do (KR)
(74) Representative: Land, Addick Adrianus Gosling

(57) **Abstract**

An actuator using a piezoelectric element (10) and a method of driving the same. The actuator includes at least one piezoelectric cell (10a,10d) moving by displacement according to an input voltage, at least one piezoelectric sensor (10b,10c) sensing the displacement of the at least one piezoelectric cell, an error detector (5) detecting an error in the at least one piezoelectric sensor, and a feedback signal generator (7) generating a feedback signal corresponding to the error, thereby performing micromirror driving and sensing.

## Description

### CROSS-REFERENCE TO RELATED APPLICATION

This application claims the benefit of Korean Application No. 10-2008-0089328, filed September 10, 2008, in the Korean Intellectual Property Office, the disclosure of which is incorporated herein by reference.

Aspects of the present invention relate to an actuator using a piezoelectric element and a method of driving the same.

Information storage technology using holograms has been developed. In information storage technology using holograms, information is stored in inorganic crystals or a polymer material that is sensitive to light, in the form of an optical interference pattern. The optical interference pattern is formed using two coherent laser beams. The optical interference pattern in which a reference light and a signal light each having a different path interfere with each other, causes a chemical or physical change and is recorded on a photosensitive storage medium. In order to reproduce information from the optical interference pattern, the reference light that is similar to the recording light is irradiated onto the optical interference pattern recorded on the storage medium. This causes diffraction due to the interference pattern, and the signal light is restored due to the diffraction and information is reproduced from the interference pattern.

Information storage technology using holograms includes a volume holography method by which information is recorded/reproduced in page units by using volume holography, and a micro-holography method by which information is recorded/reproduced in a single bit by using micro-holography. In the volume holography method, a large amount of information is simultaneously processed. However, since an optical system should be very precisely adjusted, it is difficult to commonly use the method in a related information storage apparatus for general consumers.

Meanwhile, in the micro-holography method, two concentrated lights interfere with each other and are focused to form minute interference patterns, the interference patterns are moved on a plane of a storage medium to form a plurality of recording layers, the recording layers overlap each other in a depth direction of the storage medium, thereby three-dimensionally recording information on the storage medium.

When a holography information storage apparatus storing data by recording diffraction patterns in a holography medium, by using interference of a reference light and a signal light, reproduces a signal recorded on a hologram medium or records new data, precise control of an incidence angle with respect to each medium of a reference light and a signal light is very important. In general, the holography information storage apparatus uses a galvano mirror. The size of the galvano mirror is large and is not appropriate for a small-sized optical head. In addition, when a micro-electro-mechanical system (MEMS) mirror is used, the MEMS mirror uses an electrostatic force. Thus, a driving force is small, and a driving frequency is limited to a resonant frequency. As such, the range of application is small and a degree of precision is low.

### SUMMARY OF THE INVENTION

Aspects of the present invention provide an actuator in which micromirror driving and sensing is performed by using a piezoelectric element.

Aspects of the present invention also provide a method of driving an actuator by using a piezoelectric element as a sensor.

An aspect of the present general inventive concept provides an actuator using a piezoelectric element, the actuator comprising: at least one piezoelectric cell moving by displacement according to an input voltage; at least one piezoelectric sensor sensing the displacement of the at least one piezoelectric cell; an error detector detecting an error in the at least one piezoelectric sensor; and a feedback signal generator generating a feedback signal corresponding to the error.

According to another aspect of the present invention, the error detector may include a phase locked loop (PLL) circuit.

According to another aspect of the present invention, the error detector may measure the displacement of the at least one piezoelectric cell according to a capacitance of the at least one piezoelectric sensor, compare the displacement of the at least one piezoelectric cell with a reference displacement value in order to detect the error.

According to another aspect of the present invention, the at least one piezoelectric cell include a plurality of electrode layers that are stacked upon each other.

According to another aspect of the present invention, the actuator may comprise a pair of piezoelectric cells and a pair of piezoelectric sensors and each of the piezoelectric cells faces the other piezoelectric cell and one of the piezoelectric sensors.

According to another aspect of the present invention, the actuator may further comprise: a hinge member disposed on the piezoelectric cell and the piezoelectric sensor; and a post disposed on the hinge member and supporting a micromirror.

According to another aspect of the present invention, the hinge member may comprise: a bar disposed parallel to a rotation axis of the micromirror; and a curved portion extending from the bar.

According to another aspect of the present invention, the actuator may further comprise a support member disposed between the at least one piezoelectric cell, the at least one piezoelectric sensor, and the hinge member.

According to another aspect of the present invention, the hinge member may comprise: a first plate combined with the support member; and a second plate on which the post is disposed, wherein the bar and the curved portion of the hinge member are disposed between the first plate and the second plate.

According to another aspect of the present invention, the curved portion may comprise: at least one first part disposed parallel to a rotation axis of the micromirror; and at least one second part disposed perpendicular to the rotation axis of the micromirror.

Aspects of the present invention provide a method of driving an actuator, the method comprising: moving a piezoelectric cell by displacement; detecting an error in a piezoelectric sensor that is interlocked to the piezoelectric cell according to the displacement of the piezoelectric cell; and generating a feedback signal by using the error.

According to another aspect of the present invention, the detecting of the error may comprise detecting a capacitance of the piezoelectric sensor.

According to another aspect of the present invention, the detecting of the error may comprise measuring a displacement value of the piezoelectric cell according to a capacitance of the piezoelectric sensor, comparing the measured displacement value of the piezoelectric cell with a reference displacement value, and detecting an error.

According to another aspect of the present invention, the detecting of the error may comprise detecting the error according to a phase locked loop (PLL) control method.

According to another aspect of the present invention, a hinge member may be disposed on the piezoelectric cell and the piezoelectric sensor, and the piezoelectric sensor moves the hinge member when the piezoelectric cell moves.

Additional aspects and/or advantages of the invention will be set forth in part in the description which follows and, in part, will be obvious from the description, or may be learned by practice of the invention.

### BRIEF DESCRIPTION OF THE DRAWINGS

These and/or other aspects and advantages of the invention will become apparent and more readily appreciated from the following description of the embodiments, taken in conjunction with the accompanying drawings of which:
FIG. 1 schematically illustrates an actuator using a piezoelectric element according to an embodiment of the present general inventive concept;
FIG. 2 illustrates a micromirror device of the actuator using a piezoelectric element illustrated in FIG. 1, according to an embodiment of the present general inventive concept;
FIG. 3 is a cross-sectional view taken along line II-II' of FIG. 2, according to an embodiment of the present general inventive concept;
FIG. 4 illustrates a hinge member of the actuator using a piezoelectric element illustrated in FIG. 1, according to an embodiment of the present general inventive concept;
FIGS. 5A through 5D illustrate a method of manufacturing a piezoelectric cell of the actuator using a piezoelectric element illustrated in FIG. 1, according to an embodiment of the present general inventive concept;
FIG. 6A illustrates a stack type piezoelectric cell of the actuator using a piezoelectric element illustrated in FIG. 1, according to an embodiment of the present general inventive concept;
FIG. 6B illustrates a bulk type piezoelectric cell of the actuator using a piezoelectric element illustrated in FIG. 1, according to an embodiment of the present general inventive concept;
FIGS. 7A and 7B illustrate the case where the actuator using a piezoelectric element illustrated in FIG. 1 is driven around one axis, according to an embodiment of the present general inventive concept; and
FIGS. 8A and 8B illustrate the case where the actuator using a piezoelectric element illustrated in FIG. 1 is driven around another axis, according to an embodiment of the present general inventive concept.

### DETAILED DESCRIPTION OF THE EMBODIMENTS

Reference will now be made in detail to the present embodiments of the present invention, examples of which are illustrated in the accompanying drawings, wherein like reference numerals refer to the like elements throughout. The embodiments are described below in order to explain the present invention by referring to the figures..

An actuator according to an embodiment of the present general inventive concept performs micromirror driving by using a piezoelectric element and detects displacement of a piezoelectric cell.

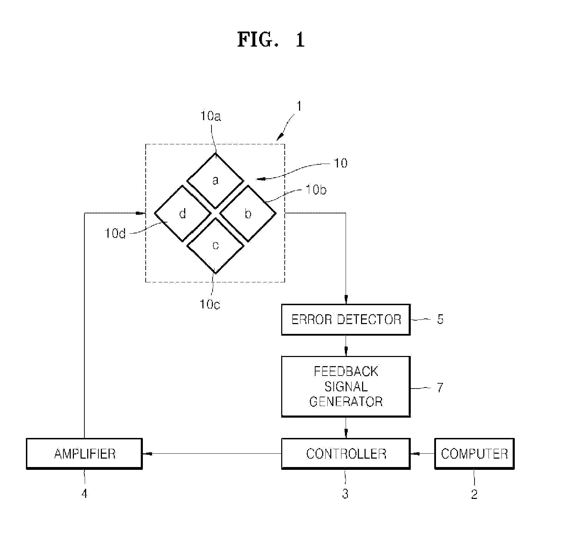

FIG. 1 schematically illustrates an actuator using a piezoelectric element according to an embodiment of the present general inventive concept. Referring to FIG. 1, the actuator according to the current embodiment includes a micromirror device 1 including a piezoelectric element 10 having at least one piezoelectric cell and at least one piezoelectric sensor, and an error detector 5 which detects error using capacitance of the piezoelectric sensor. The actuator of FIG. 1 further includes a feedback signal generator 7 and a controller 3. The feedback signal generator 7 detects a displacement error by using the capacitance detected by the error detector 5, and the controller 3 controls displacement of the piezoelectric cell so that the displacement error can be corrected.

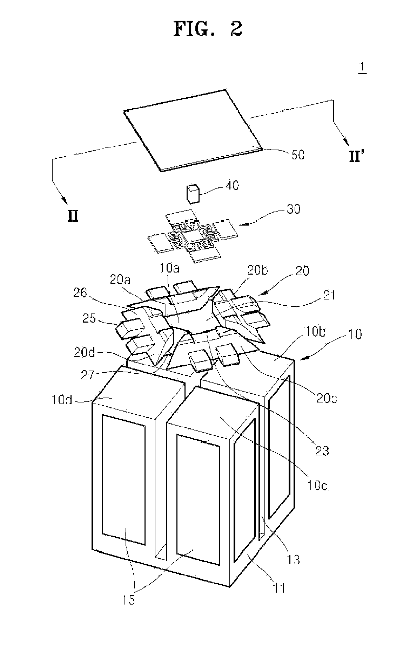

Referring to FIG. 2, the piezoelectric element 10 is used to drive a micromirror 50 and includes one or more pairs of piezoelectric cells and one or more pairs of piezoelectric sensors. For example, the piezoelectric element 10 may include a pair of piezoelectric cells and a pair of piezoelectric sensors, and the piezoelectric cells and the piezoelectric sensors may face one another. The micromirror device 1 drives the micromirror 50 by using the piezoelectric element 10.

FIG. 2 illustrates an example of the micromirror device 1. The micromirror device 1 includes a first piezoelectric cell 10a, a first piezoelectric sensor 10c which faces the first piezoelectric cell 10a, a second piezoelectric cell 10d, and a second piezoelectric sensor 10b which faces the second piezoelectric cell 10d. A hinge member 30 is installed on the piezoelectric element 10, a post 40 is disposed on the hinge member 30, and the micromirror 50 is supported on the post 40. The hinge member 30 acts as a rotation axis according to displacement of the first and second piezoelectric cells 10a and 10d so that the micromirror 50 can be tilted. The hinge member 30 may be installed directly on the piezoelectric element 10, and a support member 20 may be further disposed between the piezoelectric element 10 and the hinge member 30. Hereinafter, a structure of the actuator including the support member 20 will be described.

According to the current embodiment, a computer 2 may include data about reference displacement of a piezoelectric cell, corresponding to a tilt angle of the micromirror 50, and displacement data of a piezoelectric cell, corresponding to a capacitance-changing value of a piezoelectric sensor. A displacement error of the piezoelectric cell may be checked by the capacitance detected by the piezoelectric sensor by using the data about a reference displacement value of the piezoelectric cell, and the displacement error is reflected in the piezoelectric cell, thereby precisely controlling the micromirror 50. The reference displacement value of the piezoelectric cell corresponding to the tilt angle of the micromirror 50 is input to the controller 3 from the computer 2, and a voltage corresponding to the reference displacement value is input to a certain piezoelectric cell through an amplifier 4. The piezoelectric cell to which the voltage is input moves by displacement and a force is transmitted to the piezoelectric sensor corresponding to the piezoelectric cell that moves by displacement through the hinge member 30 so that the piezoelectric sensor moves in an upward or downward direction. For example, when a voltage is input to the first piezoelectric cell 10a, the first piezoelectric cell 10a moves by displacement, and the first piezoelectric sensor 10c that faces the first piezoelectric cell 10a is interlocked and moves by displacement. When a voltage is input to the second piezoelectric cell 10d, the second piezoelectric sensor 10b is interlocked and generates displacement.

As the first piezoelectric sensor 10c or the second piezoelectric sensor 10b moves, capacitance of the piezoelectric sensor is changed and is detected by the error detector 5. Displacement of the first piezoelectric cell 10a or the second piezoelectric cell 10d is checked from the capacitance, thereby calculating a displacement error. The feedback signal generator 7 generates a feedback signal by using the displacement error and transmits the feedback signal to the controller 3. The controller 3 controls the piezoelectric element 10 by reflecting the feedback signal on the piezoelectric element 10.

Meanwhile, as another modified example, the error detector 5 may include a phase locked loop (PLL) circuit. The PLL circuit includes an inductor having a predetermined inductance L, and an electric resonant frequency may be obtained by using a capacitance C of the piezoelectric sensor and the inductance L. The operation of the piezoelectric element 10 may be controlled by using the resonant frequency as a control variable. In this case, the computer 2 includes data about the resonant frequency corresponding to displacement of the piezoelectric cell. Such a control method is referred to as a PLL control method.

As another modified example, the error detector 5 may detect a voltage that changes according to displacement of the piezoelectric sensor and may detect an error from the voltage. When a mechanical force is applied to the piezoelectric sensor, a voltage is generated and may be measured. In this case, the computer 2 includes data about the voltage of the piezoelectric sensor corresponding to displacement of the piezoelectric cell. According to the current embodiment, an error value during micromirror driving may be detected by using the piezoelectric element 10 as a sensor.

Next, an example of the micromirror device 1 will be described. The first and second piezoelectric cells 10a and 10d may be separated from each other, and the first and second piezoelectric sensors 10b and 10c may be separated from each other. Alternatively, body portions of the first and second piezoelectric cells 10a and 10d may be separated from each other by a predetermined gap 13 and body portions of the first and second piezoelectric sensors 10b and 10c may be separated from each other by a predetermined gap 13, and base sides 11 of the first and second piezoelectric cells 10a and 10d, and the first and second piezoelectric sensors 10b and 10c may be connected to each other, as illustrated in FIG. 2. Due to the above structure, the first and second piezoelectric cells 10a and 10d and the first and second piezoelectric sensors 10b and 10c can be stably fixed. Meanwhile, electrodes 15 are disposed at sides of each of the first and second piezoelectric cells 10a and 10d and at sides of each of the first and second piezoelectric sensors 10b and 10c.

The support unit 20 is used to support the hinge member 30. The number of support members, 20a-20d, corresponds to the number of the first and second piezoelectric cells 10a and 10d and the number of the first and second piezoelectric sensors 10b and 10c, and each of the support members 20a-20d is disposed on a top surface of the piezoelectric element 10. The support 20 includes first through fourth support members 20a, 20b, 20c, and 20d. The support members 20a, 20b, 20c, and 20d may be independently separated from each other or may be connected by a connector 27 that is disposed between the adjacent support members. The connector 27 is formed of an elastic material that does not disturb the movement of the adjacent support members 20a, 20b, 20c, and 20d when each of the support members 20a, 20b, 20c, and 20d moves. Each of the support members 20a, 20b, 20c, and 20d includes a groove 23 formed in a top surface of the support member 20a, 20b, 20c, and 20d and a protrusion 25 formed at a side 26 of the support member 20a, 20b, 20c, and 20d. The side 26 of each support member 20a, 20b, 20c, and 20d may be formed as an inclined side, and each support member 20a, 20b, 20c, and 20d includes two protrusions 25. Each protrusion 25 prevents the micromirror 50 from contacting the piezoelectric element 10 when the micromirror 50 is rotated. In addition, epoxy is coated between the protrusion 25 to attach the support 20 to the piezoelectric element 10.

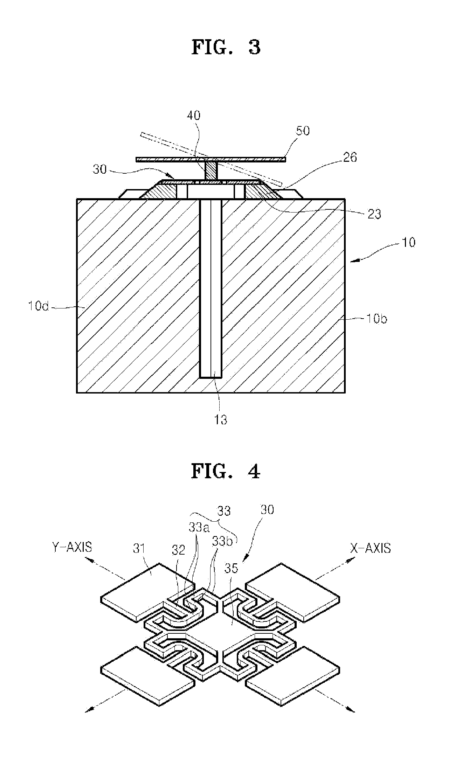

A middle portion that is encompassed by the first through fourth support members 20a, 20b, 20c, and 20d is formed as a hollow space 21, and the hollow space 21 provides a space in which the hinge member 30 moves. Referring to FIG. 3, the thickness of the support 20 is larger than the thickness of the hinge member 30, and an end of the hinge member 30 is supported by the groove 23 of the support 20 so that the hinge member 30 floats above the hollow space 21. The post 40 is disposed on the hinge member 30, and the micromirror 50 is supported by the post 40.

FIG. 4 is an expanded perspective view of the hinge member 30. The hinge member 30 includes a bar 32 that is parallel to a rotation axis of the micromirror 50, and a curved portion 33 that extends from the bar 32. The curved portion 33 includes at least one first part 33a that is parallel to a rotation axis (X-axis or Y-axis) of the micromirror 50, and at least one second part 33b that is perpendicular to the rotation axis of the micromirror 50. The first part 33a that is parallel to the rotation axis of the micromirror 50 is twisted, and the second part 33b that is perpendicular to the rotation axis of the micromirror 50 is bent. Stress is dispersed by using a portion that is twisted and a portion that is bent when the hinge member 30 moves so that precise control can be achieved.

The hinge member 30 includes a first plate 31 that is combined with the groove 23 of the support 20, and a second plate 35 on which the post 40 is disposed. The bar 32 and the curved portion 33 are disposed between the first plate 31 and the second plate 35. The curved portion 33 can disperse more stress as the curved portion 33 includes a larger number of first parts 33a and a larger number of second parts 33b compared to a related art. However, the number of the first parts 33a and the number of the second parts 33b need to be limited so that the size of the actuator can be kept small. The micromirror 50 is rotated by movement of the hinge member 30, and an X-axis or Y-axis of FIG. 4 becomes the rotation axis of the micromirror 50.

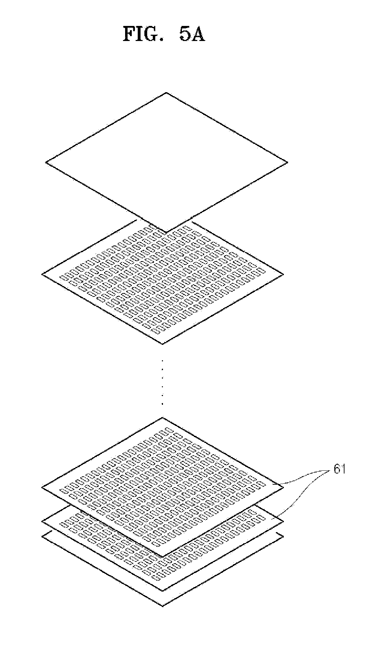

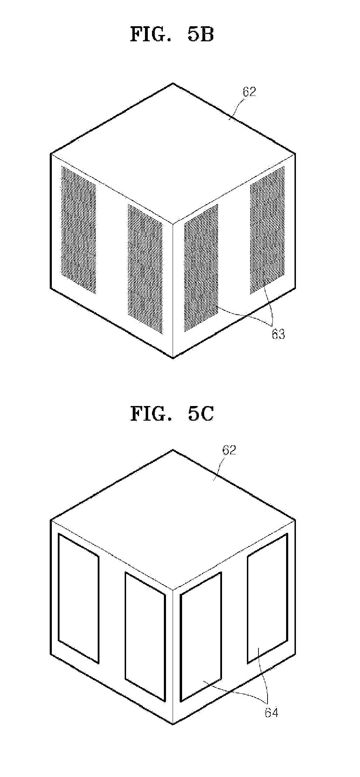

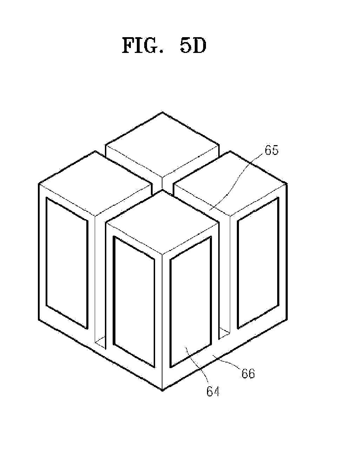

FIGS. 5A through 5D illustrate a method of manufacturing a piezoelectric element. Referring to FIG. 5A, a plurality of formation sheets 61 are manufactured. Internal electrode layers 63 are manufactured as two types of patterns which are alternately stacked on the formation sheet 61, and are pressurized by applying heat and pressure thereby forming a stack body 62, as illustrated in FIG. 5B. As illustrated in FIG. 5C, the conductive paste that is exposed to the outside of the stack body 62 is coated on the internal electrode layers 63, thereby forming electrodes 64. Then, as illustrated in FIG. 5D, the stack body 62 is cut into four cells by using dicing or saw cutting. In this case, the stack body 62 is not cut all the way to the bottom but bottom portions 66 of the stack body 62 are connected to each other. As such, a gap 65 between cells can be kept. A process, such as polishing of a ceramic side, together with a separation process may be added to the method of manufacturing the piezoelectric element, so as to make the size of a piezoelectric body constant.

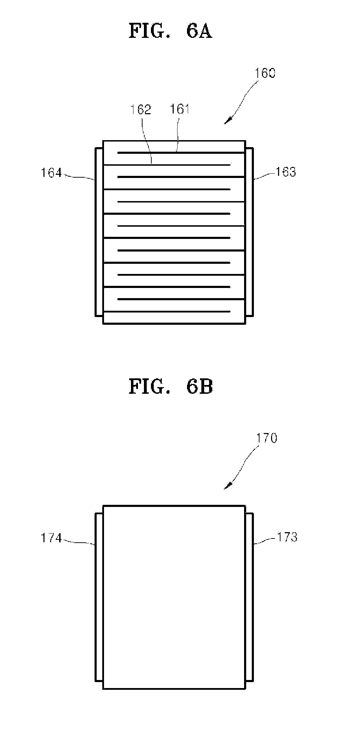

FIG. 6A illustrates a stack type piezoelectric element 160, and FIG. 6B schematically illustrates a bulk type piezoelectric element 170. A first electrode layer 161 and a second electrode layer 162 are alternately stacked on the stack type piezoelectric element 160, and first and second electrodes 163 and 164 are disposed at both sides of the stack type piezoelectric element 160. Electrode layers are not stacked on the bulk type piezoelectric element 170, and first and second electrodes 173 and 174 are disposed at both sides of the bulk type piezoelectric element 170. Consequently, when the stack type piezoelectric element 160 detects a capacitance, which is used to detect a micromirror driving error, capacitances between a plurality of pairs of first electrode layers and second electrode layers are added. As such, capacitances can be easily detected.

Next, a method of driving an actuator according to an embodiment of the present general inventive concept will be described.

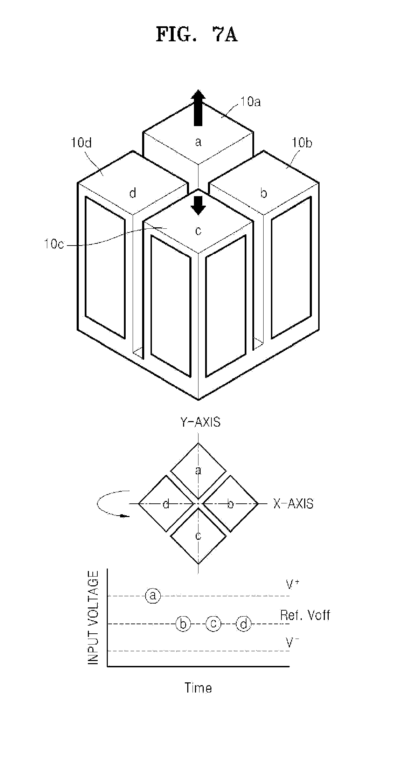

Referring to FIG. 7A in conjunction with FIG. 2, when a voltage is applied to one of the first piezoelectric cell 10a and the second piezoelectric cell 10c, displacement occurs in one of the first and second piezoelectric cells 10a and 10c according to the applied voltage, and the height of the piezoelectric cell is changed. The position of the support member 20 is changed according to displacement of the piezoelectric cell, and the hinge member 30 that is combined with the support member 20 is deformed. Due to deformation of the hinge member 30, the micromirror 50 that is supported by the post 40 in the hinge member 30 is rotated. Here, the micromirror 50 is not directly combined with the hinge member 30 but is supported by the post 40, so as to obtain a rotation space of the micromirror 50 and prevent deformation of the hinge member 30 from affecting the micromirror 50 which would prevent precise control from being achieved.

The method of driving the actuator will now be described in detail. A tilt angle of the micromirror 50 may be adjusted according to displacement of the first and second piezoelectric cells 10a and 10c. In order to precisely control the tilt angle of the micromirror 50, displacement errors of the first and second piezoelectric cells 10a and 10c are detected, and displacement of the first and second piezoelectric cells 10a and 10c is corrected by using the displacement errors. Meanwhile, in order to keep equilibrium of the piezoelectric element 10, equilibrium can be adjusted by using a signal in which light reflected from the micromirror 50 is detected by a photo diode.

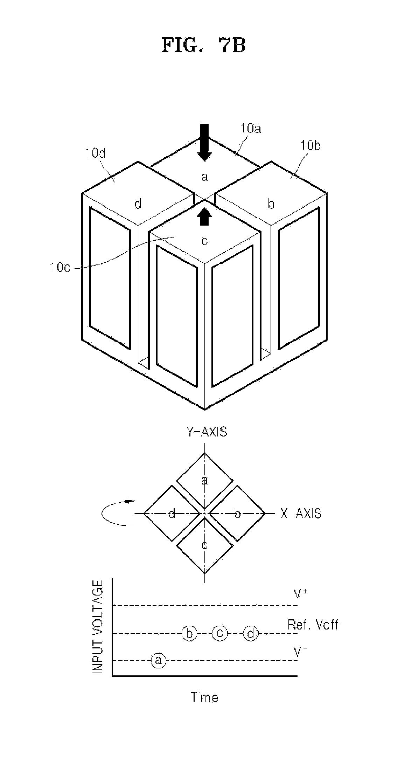

In FIGS. 7A and 7B, *a*, *b, c*, and *d* represent voltages applied to the piezoelectric element 10. Referring to FIG. 7A, when a positive (+) voltage is applied to the first piezoelectric cell 10a, the first piezoelectric cell 10a moves in an upward direction, and the first piezoelectric sensor 10c that faces the first piezoelectric cell 10a is pressurized by a support member 20 (as illustrated in FIG. 2) and a hinge member 30 (as illustrated in FIG. 2) in a downward direction. Thus, the first piezoelectric sensor 10c moves by displacement. In this case, the second piezoelectric cell 10d and the second piezoelectric sensor 10b support a rotation axis of the micromirror 50, and the micromirror 50 is tilted around an X-axis. The error detector 5 (as illustrated in FIG. 1) may detect capacitance of the first piezoelectric sensor 10c or detect a voltage or detect a resonant frequency by using a PLL control method.

Error detection using capacitance will now be described. When the first piezoelectric sensor 10c moves by displacement, a capacitance of the first piezoelectric sensor 10c changes. For example, when the stack type piezoelectric cell 160 illustrated in FIG. 6A moves by displacement, a distance between the first electrode layer 161 and the second electrode layer 162 changes. However, the capacitance depends on the area of the first electrode layer 161 and the second electrode layer 162 and a distance between the two layers 161 and 162. When the area of the first and second electrode layers 161 and 162 is constant and a distance between the first and second electrode layers 161 and 162 is changed according to displacement of the piezoelectric cell, a capacitance of the first piezoelectric sensor 10c is changed. When the capacitance of the first piezoelectric sensor 10c is detected, displacement of the piezoelectric cell may be checked by inversely calculating the capacitance.

A displacement error of the piezoelectric cell is calculated by comparing the inversely-calculated displacement value of the piezoelectric cell with a reference displacement value, and a feedback signal corresponding to correcting the displacement error is generated. Here, the reference displacement value represents displacement of a piezoelectric cell corresponding to a tilt angle of the micromirror 50. Referring to FIG. 7B, when a negative (-) voltage is applied to the first piezoelectric cell 10a, the first piezoelectric cell 10a moves in a downward direction, and the first piezoelectric sensor 10c that faces the first piezoelectric cell 10a moves in an upward direction due to a support 20 (as illustrated in FIG. 2) and a hinge member 30 (as illustrated in FIG. 2).

Table 1 shows an example of the detection of compulsive displacement of a piezoelectric cell, force applied to the piezoelectric cell, a capacitance-changing amount and displacement that occurs in a piezoelectric sensor.

**[Table 1]**

| | | | | |
|---|---|---|---|---|
| Compulsive displacement of piezoelectric cell (µm) | 0.5 | 1.0 | 1.5 | 2.0 |
| Calculated force (mN) | 0.855 | 1.71 | 2.56 | 3.42 |
| Displacement that occurs in piezoelectric sensor (pm) | 1.819e-2 | 3.64e-2 | 5.45e-2 | 7.28e-2 |
| Capacitance-changing amount (ΔC)[pF] | 0.4829e-4 | 0.9659e-4 | 1.4461e-4 | 1.9319e-4 |

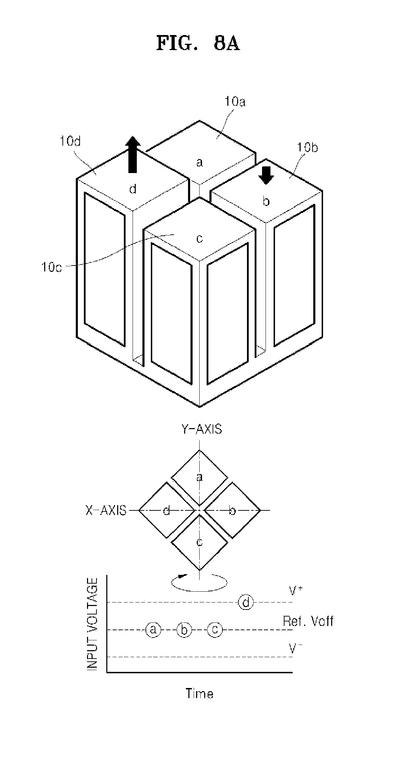

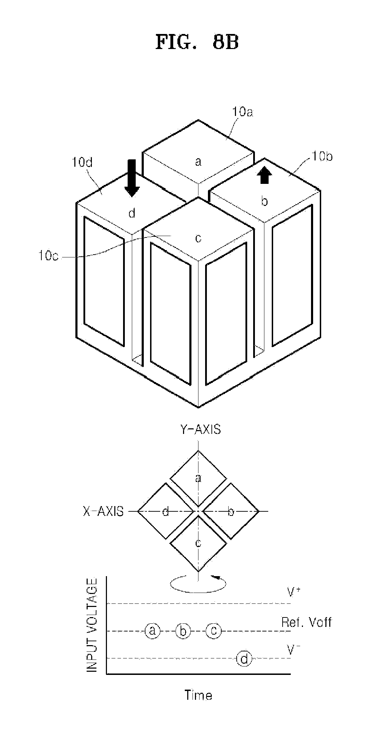

Referring to FIG. 8A, when a positive (+) voltage is applied to the second piezoelectric cell 10d, the second piezoelectric cell 10d moves in an upward direction, and the second piezoelectric sensor 10b that faces the second piezoelectric cell 10d is pressurized by the support member 20 and the hinge member 30 in a downward direction. Thus, the second piezoelectric sensor 10b moves by displacement. In this case, the first piezoelectric cell 10a and the first piezoelectric sensor 10c support the rotation axis of the micromirror 50, and the micromirror 50 is tilted around a Y-axis. Referring to FIG. 8B, when a negative (-) voltage is applied to the second piezoelectric cell 10d, the second piezoelectric cell 10d moves in a downward direction, and the second piezoelectric sensor 10b that faces the second piezoelectric cell 10d moves in an upward direction due to the support 20 and the hinge member 30. The error detector 5 detects one of a voltage, a capacitance, and a resonant frequency that change due to displacement of the second piezoelectric sensor 10b, to detect an error from the second piezoelectric sensor 10b, and the feedback signal generator 7 generates a feedback signal by using the error, and the micromirror 50 can be driven at a corrected tilt angle.

According to an embodiment of the present general inventive concept, the piezoelectric element 10 may be used as a piezoelectric cell for driving the micromirror 50 and as a sensor for detecting displacement of the piezoelectric cell. Thus, an additional sensor for detecting displacement of the piezoelectric cell is not needed and a structure of the actuator is simplified. Meanwhile, the actuator according to an embodiment of the present general inventive concept can be applied to a holography information storage apparatus, for example.

Although a few embodiments of the present invention have been shown and described, it would be appreciated by those skilled in the art that changes may be made in this embodiment without departing from the principles and spirit of the invention, the scope of which is defined in the claims and their equivalents.

## Claims

1. An actuator using a piezoelectric element, the actuator comprising:
at least one piezoelectric cell moving by displacement according to an input voltage;
at least one piezoelectric sensor sensing the displacement of the at least one piezoelectric cell;
an error detector detecting an error in the at least one piezoelectric sensor; and
a feedback signal generator generating a feedback signal corresponding to the error.

2. The actuator of claim 1, wherein the error detector comprises a phase locked loop (PLL) circuit.

3. The actuator of claim 1, wherein the error detector measures the displacement of the at least one piezoelectric cell according to a capacitance of the at least one piezoelectric sensor, compares the displacement of the at least one piezoelectric cell with a reference displacement value in order to detect the error.

4. The actuator of any one of claims 1 to 3, wherein the at least one piezoelectric cell comprises a plurality of electrode layers that are stacked upon each other.

5. The actuator of any one of claims 1 to 3, wherein the actuator comprises a pair of piezoelectric cells and a pair of piezoelectric sensors and each of the piezoelectric cells faces the other piezoelectric cell and one of the piezoelectric sensors.

6. The actuator of any one of claims 1 to 3, further comprising:
a hinge member disposed on the piezoelectric cell and the piezoelectric sensor; and
a post disposed on the hinge member and supporting a micromirror.

7. The actuator of claim 6, wherein the hinge member comprises:
a bar disposed parallel to a rotation axis of the micromirror; and
a curved portion extending from the bar.

8. The actuator of claim 6, further comprising a support member disposed between the at least one piezoelectric cell, the at least one piezoelectric sensor and the hinge member.

9. The actuator of claim 8, wherein the hinge member comprises:
a first plate combined with the support member; and
a second plate on which the post is disposed, wherein the bar and the curved portion of the hinge member are disposed between the first plate and the second plate.

10. The actuator of claim 9, wherein the curved portion comprises:
at least one first part disposed parallel to a rotation axis of the micromirror; and
at least one second part disposed perpendicular to the rotation axis of the micromirror.

11. A method of driving an actuator, the method comprising:
moving a piezoelectric cell by displacement;
detecting an error in a piezoelectric sensor that is interlocked to the piezoelectric cell according to the displacement of the piezoelectric cell; and
generating a feedback signal by using the error.

12. The method of claim 11, wherein the detecting of the error comprises detecting a capacitance of the piezoelectric sensor.

13. The method of claim 12, wherein the detecting of the error comprises measuring a displacement value of the piezoelectric cell according to a capacitance of the piezoelectric sensor, comparing the measured displacement value of the piezoelectric cell with a reference displacement value, and detecting an error.

14. The method of claim 11, wherein the detecting of the error comprises detecting the error according to a phase locked loop (PLL) control method.

15. The method of any one of claims 11 to 14, wherein a hinge member is disposed on the piezoelectric cell and the piezoelectric sensor, and the piezoelectric sensor moves the hinge member when the piezoelectric cell moves.
